# EUROPEAN PATENT APPLICATION

(11) **EP 2 874 081 A1**
(43) Date of publication of application: **20.05.2015**
(21) Application number: 13306569.8
(22) Date of filing: 15.11.2013
(51) Int. Cl.: G06F 17/50

(54) **Method for spreading elementary cells in integrated circuit**

(71) Applicant: Gemalto SA, 92190 Meudon (FR)
(72) Inventor: Loubet Moundi, Philippe, 13705 La Ciotat (FR); Courbon, Franck, 13705 La Ciotat (FR)

(57) **Abstract**

The present invention relates to a method for spreading elementary cells in integrated circuit intended to include predetermined quantities of several predetermined functions (EFi, i ∈ [1;N]), the implementation of said predetermined functions (EFi, i ∈ [1;N]) necessitating the integration of elementary cells of several kinds (A,B,C,D,E,F,G,H) on the integrated circuit, this integration leading to a predictable distribution of elementary cells while using classical automatic conception tools, said method being characterized in that it includes:
- a step of introducing (DBI1, DBI2) distribution breaking parameters (Nij, N) in the functioning of at least one automatic conception tool (Ek, k ∈ [0,5]),
- a step of using the automatic conception tool (Ek, k ∈ [0,5]) to define a broken elementary cells distribution (MR, FLO) while applying the distribution breaking parameters (Nij, N) and
- a step of automatically spreading elementary cells on the integrated circuit according to the broken elementary cells distribution (MR, FLO).

## Description

### FIELD OF THE INVENTION

The present invention relates to a method for spreading elementary cells in integrated circuit intended to include predetermined quantities of several predetermined functions, the implementation of said predetermined functions necessitating the integration of elementary cells of several kinds on the integrated circuit, this integration leading to a predictable distribution of elementary cells while using classical automatic conception tools. On a general understanding, the invention concerns integrated circuits used for secure applications and sensible to reverse engineering like smart card chips, crypto processors, authentication circuits, cipher machines and, more generally, any other circuit that is not designed for secure application but that can be a good candidate for reverse engineering for example for cloning purpose.

The invention also pertains to an integrated circuit wherein elementary cells are spread according to the method of the invention and to a device using said method.

### BACKGROUND OF THE INVENTION

Currently techniques exist to gather information of the logic part of an integrated circuit without performing extensive reverse engineering process.

The logic part of an integrated circuit is made of synthesized logic: standard cells, also named gates or elementary cells, are placed on the silicon substrate and are connected to each other to obtain the wanted function. The scale order of the number of elementary standard cells is 100, so around 100 or multiples of 100 whereas the total number of cells used in a complex circuit can be comprised between several thousands to several millions (<1M cells for a complex current smart card chip).

The standard cells are placed and connected by automatic tools that use custom criteria to optimize final chip size or power consumption.

Reversing the entire circuit for extracting hidden data could be very long and costly. Classical reverse engineering techniques require: Chip deprocessing, large amount of pictures collection for each metal layer, manual or pseudo manual analysis of the pictures to retrieve the circuit netlist and functionality.

However techniques can be used in reverse tools to speed up the process and to be able to get quickly without manual analysis the 2 following items:
1-the identification of the standard cell function without physical reverse engineering of the cell itself;
2-the identification of the areas of interest within the logic part of the circuit without full reverse engineering.

Such techniques are based on statistical gate analysis. The probability of occurrence of a specific gate within the total number of gates used can help the attacker to guess the function of the gate without performing the entire reverse engineering of the cell itself. Indeed, basic cells are widely used and, for example, NAND gates will be ranked in first whereas complex gate will arrive on last position.

The occurrence of a gate within a specific area of the chip can help the attacker to guess the function of a small area of circuit without performing an entire reverse engineering. In particular, XOR gates will be mainly placed in the coprocessor area or in encryption functions and fast access latches gates will be used for CPU ALU internal registers.

Further alternative and advantageous solutions would, accordingly, be desirable in the art.

### SUMMARY OF THE INVENTION

The present invention aims at avoiding the above-mentioned reverse engineering statistical methods to succeed while relying on automated tools.

The present invention is defined, in its broadest sense, as a method for spreading elementary cells in integrated circuit intended to include predetermined quantities of several predetermined functions, the implementation of said predetermined functions necessitating the integration of elementary cells of several kinds on the integrated circuit, this integration leading to a predictable distribution of elementary cells while using classical automatic conception tools, said method being characterized in that it includes:
- a step of introducing distribution breaking parameters in the functioning of at least one automatic conception tool,
- a step of using the automatic conception tool to define a broken elementary cells distribution while applying the distribution breaking parameters and
- a step of automatically spreading elementary cells on the integrated circuit according to the broken elementary cells distribution.

The invention enables to avoid statistical methods to succeed. The introduction of a distribution breaking parameter while using an automatic spreading of elementary cells as provided by automatic tool enables to easily and automatically spreading cells according to a statistically unexpected pattern or cell occurrence.

Therefore, the method according to the invention allows reducing the risks of malicious attacks. At least, the attacks are more complex to carry out for a malicious attacker.

According to a first embodiment, at least one predetermined function being implementable using several sets of elementary cells of different kinds, the distribution breaking parameters are quantities of each possible set used to implement the function inside the integrated circuit, the total quantity of these sets being equal to the predetermined quantity of the concerned predetermined function.

This embodiment enables to modify the elementary cells used for the implementation of a given function. By doing so, an obtained circuit will have an elementary cell distribution distinct from the one expected for a given logical design. With such an unexpected elementary cells distribution, the nature of the circuit will be very difficult to deduce. This embodiment prevents statistical analysis by changing the elementary cells occurrence distribution during design phase after logic synthesis step.

According to an advantageous feature, the quantities of each possible set used to implement the function are randomly determined.

This feature introduces an additional mixing level that will render any attack even more difficult.

In a preferred implementation of the first embodiment, said distribution breaking parameters are introduced in the functioning of a logic synthesis conception tool.

The introduction of such distribution breaking parameters in this tool will directly lead to a result of the logic synthesis conception different from the one otherwise expected.

According to a second embodiment, the distribution breaking parameters are zones defined on at least an area reserved for elementary gates implantation on the integrated circuit associated with a distribution constraint to have similar elementary cells' kind distribution on each of these zones.

This embodiment leads to an unexpected spreading of the cells as specific localization constraint is applied. With the invention elementary cells are equally or at least similarly spread among the N zones. The goal of the second embodiment is to prevent statistical analysis by changing the position of the gates during the chip design at the place and route step.

In a preferred implementation of the second embodiment, said distribution breaking parameters are introduced in the functioning of a place and route conception tool.

Such place and route conception tools will use automatically the zones constraint of the invention is order to place and route the elementary cells.

The invention also concerns a layout data stream, wherein elementary cells are spread using the method according to the invention.

Such a data stream is a well known product among the integrated circuit manufacturer. It is an essential technical product useful in the integrated circuit manufacturing.

The invention thus also relates to an integrated circuit wherein elementary cells are spread according to a layout data stream according to the invention.

At last, the invention also proposes a conception device for circuit integration having automatic conception tools, said device comprising a distribution breaking parameters introduction means to implement the method of the invention.

To the accomplishment of the foregoing and related ends, one or more embodiments comprise the features hereinafter fully described and particularly pointed out in the claims.

### BRIEF DESCRIPTION OF THE DRAWINGS

The following description and the annexed drawings set forth in detail certain illustrative aspects and are indicative of but a few of the various ways in which the principles of the embodiments may be employed. Other advantages and novel features will become apparent from the following detailed description when considered in conjunction with the drawings and the disclosed embodiments are intended to include all such aspects and their equivalents.
Figure 1 represents a flowchart of a method for spreading elementary cells in integrated circuit, this method comprising two different embodiments of the invention and resulting in the production of a final layout data stream, typically a Graphic Data System II stream;
Figure 2 shows three different implementations for a logical AND gate in terms of elementary cells, as used in the first embodiment of the invention;
Figure 3 shows two different implementations for a logical NAND gate in terms of elementary cells, as used in the first embodiment of the invention; Figures 4A, 4B and 4C show an example of the evolution in the elementary cells distribution as obtained in the eventually obtained integrated circuit when the first embodiment of the invention is applied;
Figures 5A, 5B and 5C show an example of the evolution in the elementary cells distribution on the eventually obtained integrated circuit as obtained when the second embodiment of the invention is applied.

### DETAILED DESCRIPTION OF EMBODIMENTS OF THE INVENTION

For clarity, only those elements and steps which are useful to the understanding of the present invention have been shown in the drawings and will be described.

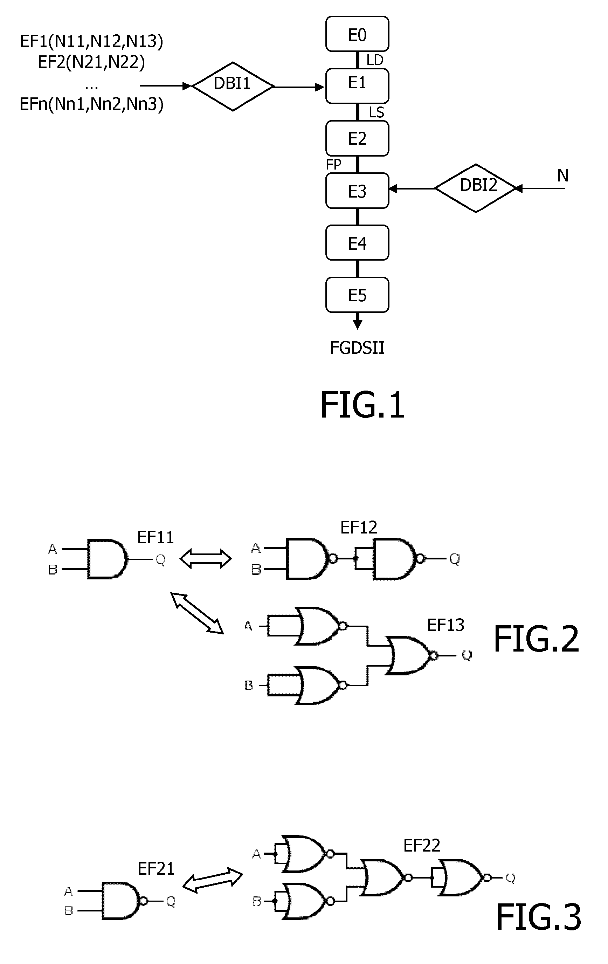

FIG. 1 schematically represents a flowchart of a method for spreading elementary cells in integrated circuit. It summarizes the chip design between chip specification and final mask generation (GDSII files generated for mask processing). Such a method typically results in the production of a final layout data stream, typically a Graphic Data System II stream. This method includes a first step E0 of determining a logic design LD for the integrated circuit to be obtained. Such a logic design LD lists the logical functions to be implemented.

Then in a step E1 a logic synthesis LS is performed. During this step, the elementary cells to implement each logical function are determined.

Design process floorplans FP are then created during a floorplanning design step E2, which is an early stage in the hierarchical approach to chip design.

However, depending on the design methodology being followed, the actual definition of a floorplan FP may differ.

Floorplanning takes typically in account some of the geometrical constraints in a design. Examples of this are: bonding pads for off-chip connections are normally located at the circumference of the chip, line drivers often have to be located as close to bonding pads as possible, chip area is given a minimum area in order to fit in the required number of pads, areas are clustered in order to limit data paths thus frequently featuring defined structures such as cache RAM, multiplier, barrel shifter, line driver and arithmetic logic unit, IP-blocks, such as a processor core, come in predefined area blocks, some IP-blocks come with legal limitations such as permitting no routing of signals directly above the block.

The floorplanning step is followed by a step E3 of placing and routing. Then a step E4 of determining a first Graphic Data System II stream is performed. The design rules are then verified and the GDSII is validated using electrical simulation in a verification step E5.

At last a final Graphic Data System stream FGDSII is obtained. This stream is directly used in integrated circuit manufacturing machines to control the circuit integration. The obtained integrated circuit is fully determined in such GDSII stream.

Figure 1 presents two embodiments of the invention. The first one is applied to step E1 of logical synthesis of the integrated circuit. The second one is applied on the placing and routing step E3.

Concerning the first embodiment, normally at the end of step E1, the number of elementary cell is known and a distribution function ranking the number of occurence of each cell can be generated. This can lead to successful attack.

After step E0, the number of elementary functions EF to be implemented is known in the logic design LD.

According to the first embodiment of the invention, a step DBI1 of introduction of distribution breaking parameters are introduced in the logical synthesis step E1. These distribution breaking parameters are quantities Nn1,Nn2,Nn3 of each possible set, here 1,2,3, used to implement an elementary function EFn inside the integrated circuit. The total quantity of these sets is Nn1+Nn2+Nn3 equal to the predetermined number of the concerned predetermined elementary function EFn defined in the logic design LD.

Indeed, this embodiment of the invention here exploits the fact that each elementary function can be implemented using several combination of elementary cells.

Two examples of such multiple possible implementations for same elementary functions are given on figure 2 and 3.

Figure 2 shows three different implementations EF11, EF12, EF13 for a logical AND elementary function in terms of elementary cells. For example, EF1 as presented in figure 1 is this AND elementary function having three possible implementation. N11, N12, N13 are thus the quantities of each of the three different possible implementations and are the distribution breaking parameters for this embodiment. In EF12, the AND cell EF11 is replaced by two NAND cells. In EF13, the AND cell EF11 is replaced by three NOR cells. It enables to replace elementary cells by several other elementary cells doing the same function.

Figure 3 shows two different implementations EF21 and EF22 for a logical NAND elementary function in terms of elementary cells. While considering figure, the NAND function is for example EF2 and N21, N22 are the quantities of each of the two possible implementations. Here, in EF21, the logical NAND gate is replaced by four NOR gates.

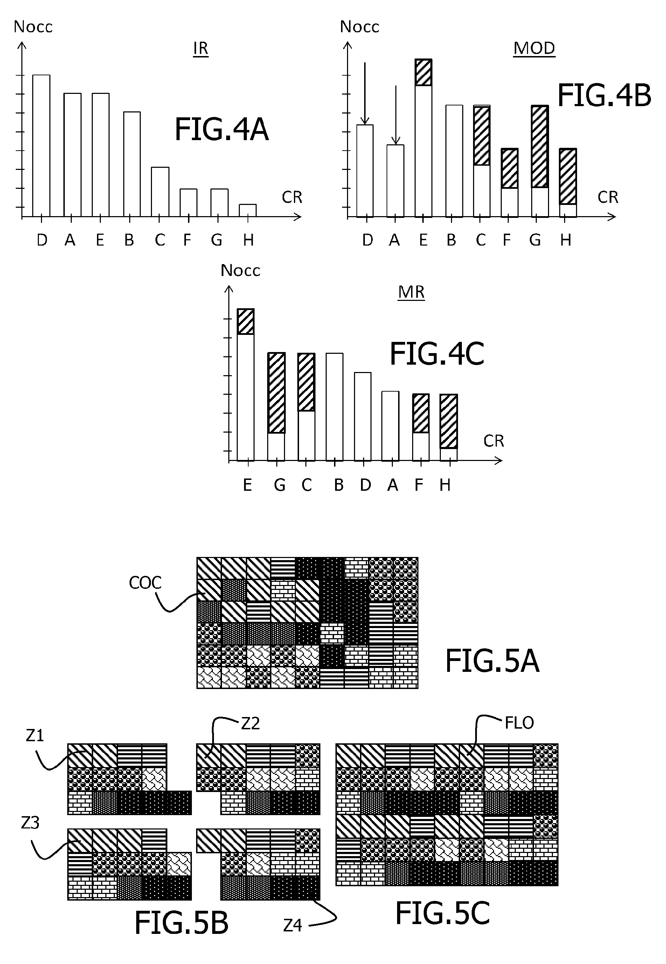

Figures 4A, 4B and 4C show an example of the evolution the elementary cells ranking CR as obtained when the first embodiment of the invention is applied. These figures show the number of occurrences Nocc of each cell A to H. Figure 4A shows an initial repartition IR of several elementary cells A to H, the cells being classified from the most current to the least current one. Here cells D are the most common while cells H are the less common cells encountered, the order being DAEBCFGH.

Figure 4B shows the changes MOD in the number of occurrences Nocc for each kind of cells, still ranked as on figure 4A. For a given elementary cell, the number of occurrence Nocc is modified by replacing this elementary cell by several other elementary cells that do the same function. It can be seen that cells D and A have a decreasing number of occurrences while cells E, C, F, G, H have increasing number of occurrences. To obtain such modifications, elementary cells are replaced by the equivalent function made of other elementary cells. It leads to a change of the overall cell ranking within the distribution. The substitution can be done by replacing an elementary cell by an equivalent function randomly chosen among a set of possible combinations of elementary cells as shown on figure 2 and 3.

Figure 4C shows the broken cells distribution as a modified cells distribution MR after reordering of the cells according to the number of their occurrences. The new order is EGCBDAHF. The invention modifies the cell distribution and the ranking and it avoids any analysis of the ranking of cells that can leak information about the function of the cell.

This embodiment does not require any modification of standard elementary cells and is fully compatible with standard automated tools.

Figures 5A, 5B and 5C show an example of the evolution in the elementary cells distribution as obtained when the second embodiment of the invention is applied. This embodiment is implemented during the place and route step E3.

Without the invention, at the end of this step, the elementary cells are grouped to minimize surface and connections between gates. Figure 5A shows an example of such a classically obtained circuit COC made of 54 elementary cells as a total number of cells. Seven different kinds of cells represented by different filings of each square are present. It can be seen that cells are grouped in specific way, this way enabling an attacker to deduce the purpose of the circuit or at least to know if this is a sensitive zone or not.

The invention introduces a number N of zones in the integrated circuit as distribution breaking parameter. Figure 5B shows the effect of such a distribution breaking parameter, here equal to 4, on the elementary cells spreading. The rules to implement this embodiment in such an automated tool are the followings.

After the floor-planning step, during the place and route step, the area reserved for the elementary cells implantations is subdivided in N zones Zn. The total number of each cell Ci is divided by N and Ci/N gates is placed in each zone. The N number can be chosen between the following interval N ∈ [2,TGn/NEC] where TGn is the total number of logic gates (elementary cells) used for the complete circuit, here 54, and NEC is the Number of Elementary Cells, here 7. The choice of number N could be adjusted depending on the wanted security level (more zones, more security).

The effect of this embodiment of the invention on the obtained layout appears clearly on figure 5B as cells are now spread again according to the automated tool rules but in four different independent zones of the circuit.

Figure 5C shows the obtained broken cells distribution in the form of a final obtained layout FLO of the circuit once the four zones Z1 to Z4 have been grouped. This embodiment does not require any modification of standard cells and is fully compatible with standard automated tools as soon as constraints in placement are offered by such a tool.

In the above detailed description, reference is made to the accompanying drawings that show, by way of illustration, specific embodiments in which the invention may be practiced. These embodiments are described in sufficient detail to enable those skilled in the art to practice the invention. It is to be understood that the various embodiments of the invention, although different, are not necessarily mutually exclusive. The above detailed description is, therefore, not to be taken in a limiting sense, and the scope of the present invention is defined only by the appended claims, appropriately interpreted, along with the full range of equivalents to which the claims are entitled.

## Claims

1. Method for spreading elementary cells in integrated circuit intended to include predetermined quantities of several predetermined functions (EFi, i ∈ [1;N]), the implementation of said predetermined functions (EFi, i ∈ [1;N]) necessitating the integration of elementary cells of several kinds (A,B,C,D,E,F,G,H) on the integrated circuit, this integration leading to a predictable distribution of elementary cells while using classical automatic conception tools, said method being **characterized in that** it includes:
- a step of introducing (DBI1, DBI2) distribution breaking parameters (Nij, N) in the functioning of at least one automatic conception tool (Ek, k ∈ [0,5]),
- a step of using the automatic conception tool (Ek, k ∈ [0,5]) to define a broken elementary cells distribution (MR, FLO) while applying the distribution breaking parameters (Nij, N) and
- a step of automatically spreading elementary cells on the integrated circuit according to the broken elementary cells distribution (MR, FLO).

2. Method according to claim 1, wherein, at least one predetermined function (EFi) being implementable using several sets (EFij) of elementary cells of different kinds, the distribution breaking parameters are quantities (Nij) of each possible set used to implement the function (EFi) inside the integrated circuit, the total quantity (∑Nij) of these sets (EFij) being equal to the predetermined quantity of the concerned predetermined function (EFi).

3. Method according to claim 2, wherein the quantities (Nij) of each possible set (EFij) used to implement the function (EFi) are randomly determined.

4. Method according to one of claims 2 and 3, wherein said distribution breaking parameters (Nij) are introduced in the functioning of a logic synthesis conception tool (E1).

5. Method according to claim 1, wherein, the distribution breaking parameters are a number (N) of zones (Zi) defined on at least an area reserved for elementary gates implantation on the integrated circuit associated with a distribution constraint to have similar elementary cells' kind distribution on each of these zones (Zi).

6. Method according to claim 5, wherein said distribution breaking parameters (N) are introduced in the functioning of a place and route conception tool (E3).

7. Layout data stream (FGDSII), wherein elementary cells are spread using the method according to one of the previous claims.

8. Integrated circuit wherein elementary cells are spread according to a layout data stream (FGDSII) according to claim 7.

9. Conception device for circuit integration having automatic conception tools (Ek, k ∈ [0,5]), said device comprising a distribution breaking parameters introduction means (DBI1,DBI) to implement the method of any one of claims 1 to 6.
